# EUROPEAN PATENT APPLICATION

(11) **EP 1 338 914 A2**
(43) Date of publication of application: **27.08.2003**
(21) Application number: 03076155.5
(22) Date of filing: 19.11.1996
(51) Int. Cl.: G02F 1/1362

(54) **Method for manufacturing liquid crystal display**

(30) Priority: 21.11.1995 KR 9542618; 30.04.1996 KR 9613912
(62) Divisional of application: 96308344.9
(71) Applicant: SAMSUNG ELECTRONICS CO., LTD., Suwon-City, Kyungki-do (KR)
(72) Inventor: Lee, Jueng-gil, 107-103 Chungkoo Apt., Seongnam-city, Kyungki-do (KR); Nam, Hyo-rak, Ka-209 Sunghwan Villa, Icheon-gun, Kyungki-do (KR); Lee, Jung-ho, Suwon-city, Kyungki-do (KR)
(74) Representative: Greene, Simon Kenneth

(57) **Abstract**

A method for manufacturing a liquid crystal display is provided. The method includes the steps of forming a gate electrode and a gate line on a substrate, wherein said gate electrode and said gate line comprises at least one refractory metal layer;
forming an insulating film on said gate electrode and said gate line;
forming an amorphous silicon film pattern and a doped amorphous silicon film pattern on said insulating film, wherein said doped amorphous silicon film pattern is formed entirely on said amorphous silicon film pattern and a whole bottom surface of said doped amorphous silicon film pattern is directly contacted to said amorphous silicon film pattern;
forming a source electrode and a drain electrode composed of a third metal film and then etching away a portion of said doped amorphous silicon film pattern located between said source electrode and said drain electrode;
forming a protection film pattern having a first contact hole which exposes a portion of said drain electrode and a second contact hole which exposes a portion of said gate line, wherein said protection film pattern contacts a top surface of said amorphous silicon pattern located between said source electrode and said drain electrode and said insulating film under said second contact hole is etched away to expose a portion of said gate line; and
forming a first pixel electrode pattern which is connected to said drain electrode through said first contact hole and a second pixel electrode pattern which is electrically connected to said gate line through said second contact hole. It is thus possible to reduce the number of photolithography processes and to prevent a battery effect and generation of a hillock.

## Description

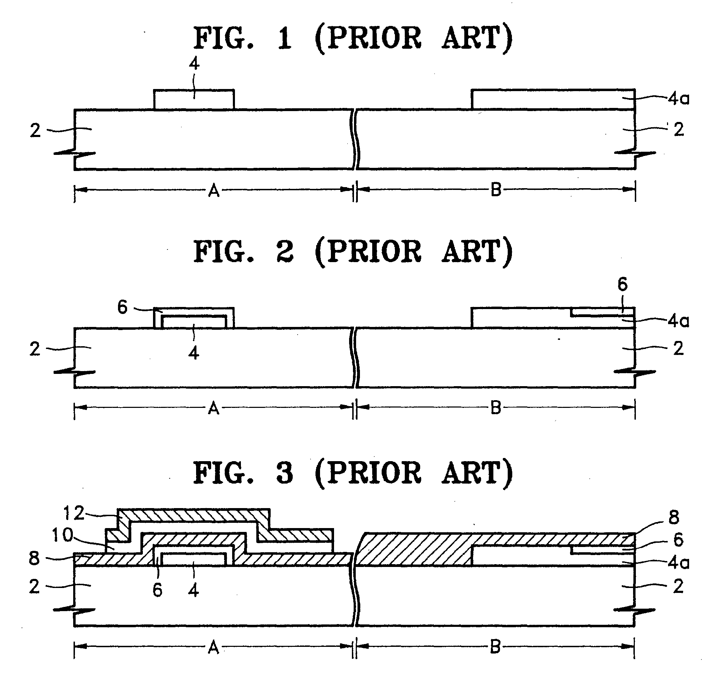

The present invention relates to a method for manufacturing a liquid crystal display. In particular aspects, it relates to an improved method for manufacturing a thin film transistor-liquid crystal display in which the number of photolithography processes to be performed is reduced.
A thin film transistor LCD (referred to hereinafter as TFT-LCD) which uses a thin film transistor as the active device has various advantages such as low power consumption, low voltage drive, thinness, and light weight, for example.
Since a thin film transistor (TFT) is significantly thinner than a conventional transistor, the process of manufacturing one is complicated, so productivity is low and manufacturing costs are high. In particular, since a mask is used in every manufacturing step, at least seven masks are required. Various methods for increasing productivity in manufacturing the TFT and in lowering the manufacturing costs have been studied. In particular, a method for reducing the number of the masks used during the manufacturing process has been widely researched. FIGS. 1 to 5 are sectional views for explaining the method for manufacturing an LCD according to a conventional technology as disclosed in U.S. Patent No. 5,054,887.
In the drawings, reference characters **A** and **B** denote a TFT area and a pad area, respectively. Referring to FIG. 1, after forming a first metal film by depositing pure Al on a transparent substrate 2, gate patterns 4 and 4a are formed by performing a first photolithography step on the first metal film. The gate patterns are used as a gate electrode 4 in the TFT area and as a gate pad 4a in the pad area.

Referring to FIG. 2, after forming a photoresist pattern (not shown) which covers a portion of the pad area by performing a general photolithography step, an anodized film 6 is formed by oxidizing the first metal film using the photoresist pattern as an anti-oxidation film. At this time, the anodized film 6 is formed on the entire surface of the gate electrode 4 formed in the TFT area and on a portion of the gate pad 4a in the pad area.

Referring to FIG. 3, an insulating film 8 is formed by depositing, for example, a nitride film on the entire surface of the substrate 2 having the anodized film thereon. Then, after forming a semiconductor film by subsequently depositing an amorphous silicon film 10 and an amorphous silicon film 12 doped with impurities on the entire surface of the substrate 2 on which the insulating film 8 is formed, a semiconductor film pattern 10 and 12 to be used as an active portion is formed in the TFT area by performing a third photolithography step on the semiconductor film.

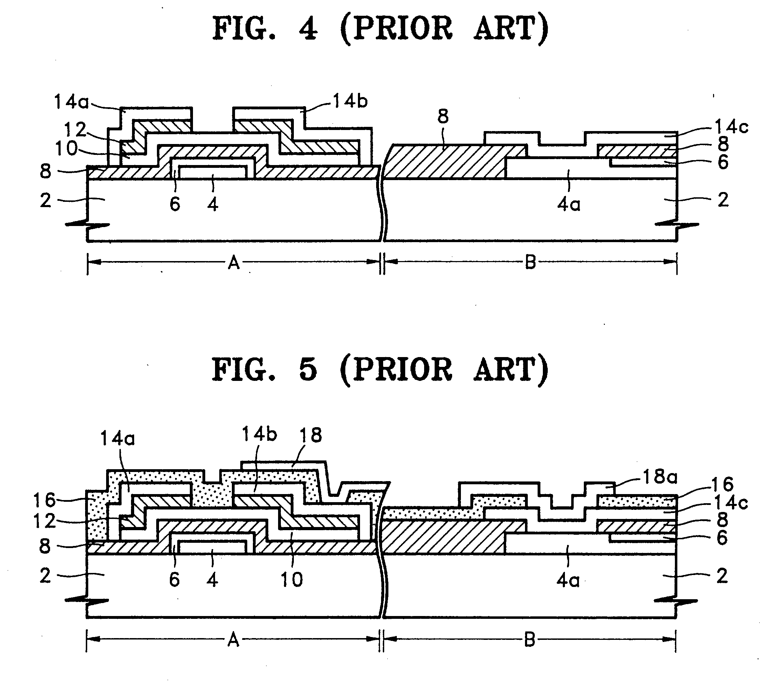

Referring to FIG. 4, a photoresist pattern (not shown) is formed which exposes a portion of the gate pad 4a formed in the pad area by performing a fourth photolithography step on the entire surface of the substrate 2 on which the semiconductor film pattern is formed. A contact hole which exposes a portion of the gate pad 4a is then formed by etching the insulating film 8 using the photoresist pattern as a mask. Then, a source electrode 14a and a drain electrode 14b are formed in the TFT area by depositing a Cr film on the entire surface of the substrate having the contact hole thereon and performing a fifth photolithography step on the Cr film. In the pad area, a pad electrode 14c connected to the gate pad 4a through the contact hole is formed. At this time, the impurity doped-amorphous silicon film 12 on the upper portion of the gate electrode 4 formed in the TFT area during the photolithography process is partially etched, thus exposing a portion of the amorphous silicon film 10.

Referring to FIG. 5, a protection film 16 is formed by depositing an oxide film on the entire surface of the substrate 2 on which the source electrode 14a, the drain electrode 14b and the pad electrode 14c are formed. Then, contact hole which exposes a portion of the drain electrode 14b of the TFT area and which expose a portion of the pad electrode 14c of the pad area are formed by performing a sixth photolithography step on the protection film.

Subsequently, pixel electrodes 18 and 18a are formed by depositing indium tin oxide ITO, which is a transparent conductive material, on the entire surface of the substrate having the contact holes and performing a seventh photolithography step on the ITO film. As a result, the drain electrode 14b and the pixel electrode 18 are connected in the TFT area and the pad electrode 14c and the pixel electrode 18a are connected in the pad area.

According to the conventional method for manufacturing the LCD, pure Al is used as the gate electrode material for lowering the resistance of a gate line. Therefore, an anodizing process is required to prevent a hillock caused by the Al, thus complicating the manufacturing process, reducing productivity, and increasing manufacturing costs.

JP 61-193128 discloses a matrix type display device having a bottom gate formed of aluminium with a chromium layer on top. A gate insulator layer, a semiconductor layer and a pixel electrode are formed.

EP 312389 discloses a liquid crystal panel in which an indium tin oxide (ITO) film may be formed on the terminal electrodes as well as forming the picture elements.

According to the invention there is provided a method for manufacturing a liquid crystal display as set out in claim 1.

It is an object of the present invention to provide an improved method for manufacturing a liquid crystal display in which manufacturing costs are reduced and productivity increased by reducing the number of photolithography processes performed.

It is another object of the present invention to provide a method for manufacturing a liquid crystal display by which it is possible to prevent deterioration of device characteristics by preventing generation of an undercut in a gate electrode.

This application also describes an improved method for manufacturing a liquid crystal display, comprising the steps of forming a gate electrode and a gate pad by sequentially depositing a first metal film and a second metal film on a substrate of a TFT area and a pad area, respectively, by a first photolithography process, forming an insulating film on the entire surface of the substrate on which the gate electrode and the gate pad are formed, forming a semiconductor film pattern on the insulating film of the TFT are using a second photolithography process, forming a source electrode and a drain electrode composed of a third metal film in the TFT area using a third photolithography process, forming a protection film pattern which exposes a portion of the drain electrode and a portion of the gate pad on the substrate on which the source electrode and the drain electrode are formed using a fourth photolithography process, and forming a pixel electrode connected to the drain electrode and the gate pad on the substrate on which the protection film pattern is formed using a fifth photolithography process.

The step of forming the semiconductor film pattern comprises the steps of depositing an amorphous silicon film and a doped amorphous silicon film on said insulating film and patterning the amorphous silicon film and the doped amorphous silicon film. The doped amorphous silicon film between the source electrode and the gate electrode is etched.

The first metal film is preferably formed of Al or Al alloy and the second metal film is preferably formed of one metal selected from the group consisting of Cr, Ta, Mo and Ti.

The step of forming the gate electrode includes the steps of forming the first metal film and the second metal film on a substrate in the described order, forming a photoresist pattern on a portion of the second metal film, etching the second metal film using the photoresist pattern as a mask, reflowing the photoresist pattern, etching the first metal film using the reflowed photresist pattern as a mask, and removing the reflowed photoresist pattern. At this time, the second metal film is overetched in the step of etching the second metal film to generate an undercut. The step of reflowing the photoresist pattern are performed in multiple steps.

The step of forming the gate electrode preferably includes the steps of forming the first metal film and the second metal film on the substrate in the described order, forming a photoresist pattern on a portion of the second metal film, etching the second metal film by dry etching using the photoresist pattern as a mask and etching the first metal film. At this time, the second metal film is preferably wet or dry etched and the step of baking the photoresist pattern is preferably further comprised after the step of etching the second metal film.

The step of forming the gate electrode preferably includes the steps of forming the first metal film and the second metal film on a substrate, forming a photoresist pattern on a portion of the second metal film, etching the second metal film using the photoresist pattern as a mask, etching the first metal film using the patterned second metal film, and re-etching the patterned second metal film. At this time, the step of baking the photoresist pattern is preferably further comprised prior to the step of etching the first metal film after etching the second metal film.

The pixel electrodes preferably comprise indium tin oxide (ITO). The pixel electrode preferably remains on the gate pad in the step of forming a pixel electrode.

According to the present invention, it is possible to prevent a battery effect and a hillock caused by directly contact of Al to the ITO by forming the gate electrode in a double structure of Al or an Al alloy and a refractory metal film. Also, it is possible to omit the anodizing process and to simultaneously etch the insulating layer and the protection film due to a capping film, thus reducing the number of the photolithography processes. Also, since it is possible to form the first metal film larger than or identical to the second metal film, an undercut is not generated in the gate electrode. Therefore, it is possible to prevent the deterioration of insulation characteristics due to poor step coverage during deposition of the insulating film after forming the gate electrode.

Specific embodiments of the present invention are described in detail below, by way of example, with reference to the attached drawings, in which:
FIGS. 1 through 5 are sectional views for explaining a method for manufacturing liquid crystal display according to a conventional method;
FIG. 6 is a schematic plan view of the mask patterns used for manufacturing a liquid crystal display according to embodiments of the present invention;
FIGS. 7 through 11 are sectional views for explaining a method for manufacturing a liquid crystal display according to a first embodiment of the present invention;
FIG. 12 is a sectional view showing generation of an undercut in a gate electrode;
FIGS. 13 through 16 are sectional views for explaining a method for manufacturing a liquid crystal display according to a second embodiment of the present invention;
FIGS. 17 through 19 are sectional views for explaining a method for manufacturing a liquid crystal display according to a third embodiment of the present invention; and
FIGS. 20 through 23 are sectional views for explaining a method for manufacturing a liquid crystal display according to a fourth embodiment of the present invention.

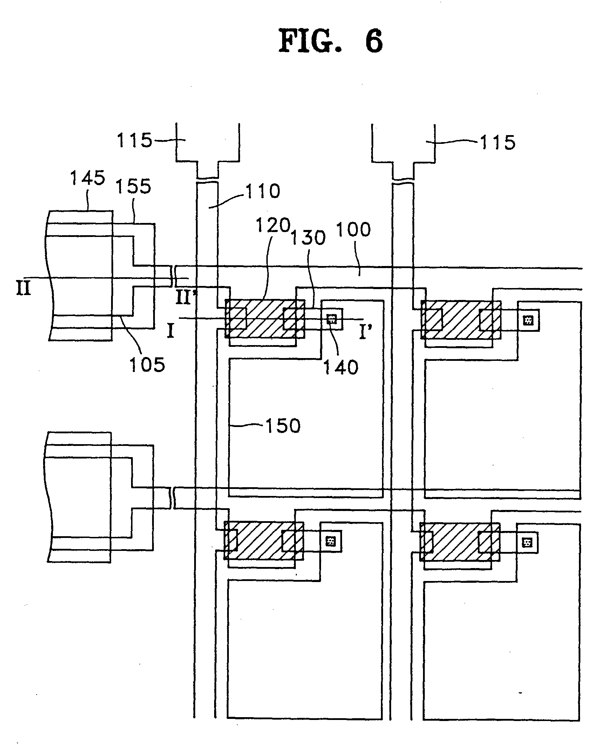

FIG. 6 is a schematic plan view of the mask patterns used for manufacturing a liquid crystal display according to embodiments of the present invention, in which reference numeral 100 denotes a mask pattern for forming a gateline, reference numeral 105 denotes a mask pattern for forming a gate pad, reference numeral 110 denotes a mask pattern for forming a data line, reference numeral 120 denotes a mask pattern for forming a semiconductor film, reference numeral 130 denotes a mask pattern for forming a source electrode/drain electrode, reference numeral 140 denotes a mask pattern for forming a contact hole for connecting a pixel electrode to the drain electrode in the TFT area, reference numeral 145 denotes a mask pattern for forming a contact hole for connecting a gate pad in the pad area to the pixel electrode, reference numeral 150 denotes a mask pattern for forming a pixel electrode in the TFT area, and reference numeral 155 denotes a mask pattern for forming a pixel electrode in the pad portion.

Referring to FIG. 6, the gate line 100 is horizontally arranged, the data line 110 is arranged in a matrix pattern perpendicular to the gate line, the gate pad 105 is provided at the end portion of the gate line 100, and the data pad 115 is provided at the end portion of the data line. Pixel portions are respectively arranged in the matrix pattern in the portion bounded by the two adjacent gate lines and the data line. The gate electrodes of the respective TFTs are formed so as to protrude to the pixel portions from the respective gate lines. The semiconductor film 120 is formed between the drain electrodes of the respective TFTs and the gate electrodes of the respective TFTs. The source electrodes of the TFTs are formed in protruding portions from the data line 110. The pixel electrodes 150 composed of the transparent ITO are formed in the respective pixel portions.

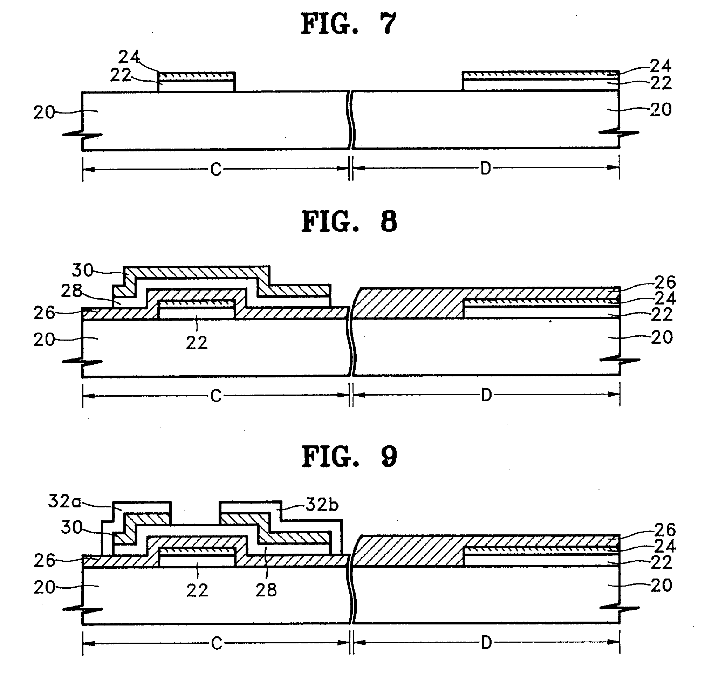

FIGS. 7 through 11 are sectional views for explaining a method for manufacturing a liquid crystal display according to a first embodiment of the present invention. Reference character **C** represents the TFT area, which is a sectional view taken along I-I' of FIG. 6 and reference character **D** represents the pad area, which is a sectional view taken along II-II' of FIG. 6.

FIG. 7 shows the steps for forming the gate electrode, in which a first metal film 22 is formed by depositing an Al or an Al alloy film to a thickness of 2,000-4,000Å on a transparent substrate 20. Then, a second metal film 24 is formed by depositing a refractory metal film to a thickness 500-2,000Å on the first metal film. Then, gate patterns are formed in the TFT area and the pad area by performing a first photolithography step on the first and the second metal films 22 and 24. The gate patterns are used as a gate electrode in the TFT area and used as a gate pad in the pad area. At this time, the first and the second metal films are wet or dry etched using a mask.

Here, the first metal film 22 is formed of Al or an Al alloy such as Al-Nd or Al-Ta. It is possible to lower the resistance of the gate line and to prevent generation of a hillock when the gate electrode is formed of such an Al alloy. The second metal film 24, which is a capping film to prevent the Al alloy from contacting the ITO film to be formed in a subsequent process, is formed of one refractory metal selected from the group consisting of Cr, Ta, Mo, and Ti. Due to the capping film on the Al or Al alloy, a high temperature oxidation process and a photolithography process for forming an oxidized film are not required. Also, since the second metal film 24 does not include Al, a battery effect generated in the conventional technology does not arise even though the second metal film 24 directly contacts the ITO film to be formed in a subsequent process.

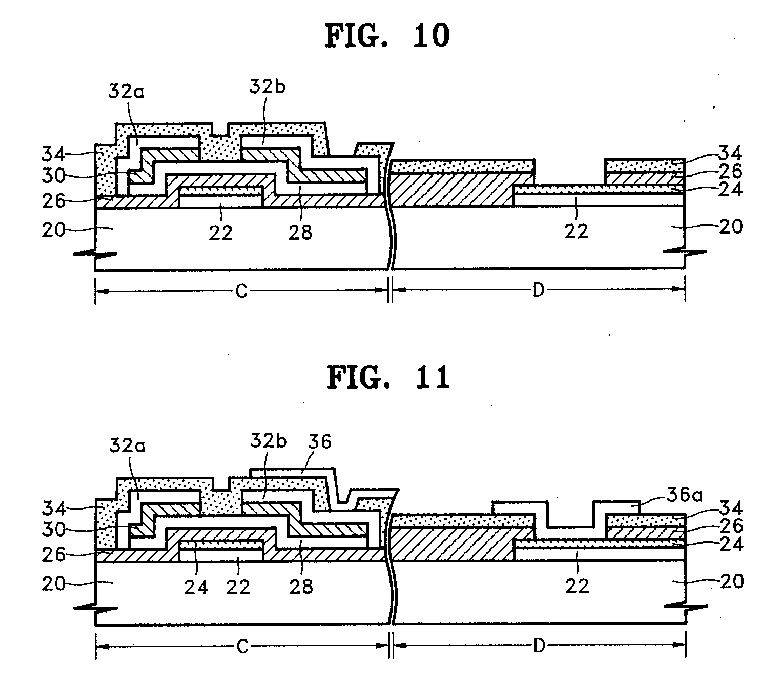

FIG. 8 shows the steps for forming a semiconductor film pattern, in which an insulating film 26 is formed by depositing a nitride film to a thickness of about 4,000Å on the entire surface of the substrate on which a gate pattern is formed. Subsequently, a semiconductor film composed of an amorphous silicon film 28 and an impurity doped-amorphous silicon film 30 is formed to a thickness of 1,000-2,000Å and a thickness of 500Å on the insulating layer 26. Then, the semiconductor film pattern to be used as an active area is formed in the TFT area by performing a second photolithography step on the semiconductor film.

FIG. 9 shows the steps for forming a source electrode and a drain electrode. A third metal film is formed by depositing a Cr film to a thickness of 1,000-2,000Å on the entire surface of the substrate 20 on which the semiconductor film pattern is formed by a sputtering method. A source electrode 32a and a drain electrode 32b are then formed in the TFT area by performing a third photolithography step on the third metal film.

FIG. 10 shows the steps for forming a protection film pattern. The protection film is formed by depositing an insulating material, e.g., an oxide film, to a thickness of 1,000-3,000Å on the entire surface of the substrate on which the source electrode 32a and the drain electrode 32b are formed. Then, a protection film pattern 34, which exposes a portion of the drain electrode 32b and a portion of the gate electrode 22 and 24 formed in the pad area, i.e., a gate pad, is formed by performing a fourth photolithography step on the protection film. In the pad area, the protection film 34 and the insulating film 26 which are formed on the gate pad are etched simultaneously.

FIG. 11 shows the steps for forming a pixel electrode. After forming the ITO film, which is a transparent conductive film, by a sputtering method on the entire surface of the substrate on which the protection film pattern is formed, pixel electrodes 36 and 36a are formed in the TFT area and the pad area by performing a fifth photolithography step on the ITO film. As a result, the pixel electrode 36 and the drain electrode 32b are connected in the TFT area and the pixel electrode 36a and the gate pad 22 and 24 are connected in the pad area.

According to the method for forming a liquid crystal display according to a first embodiment of the present invention, a battery effect and an Al hillock caused by contact of the Al to the ITO is prevented by forming a gate electrode using an Al or Al alloy and by forming a capping film on the gate electrode using a refractory metal. Also, it is possible to reduce the number of photolithography processes by omitting the anodizing process and simultaneously forming the contact on the insulating film and the protection film.

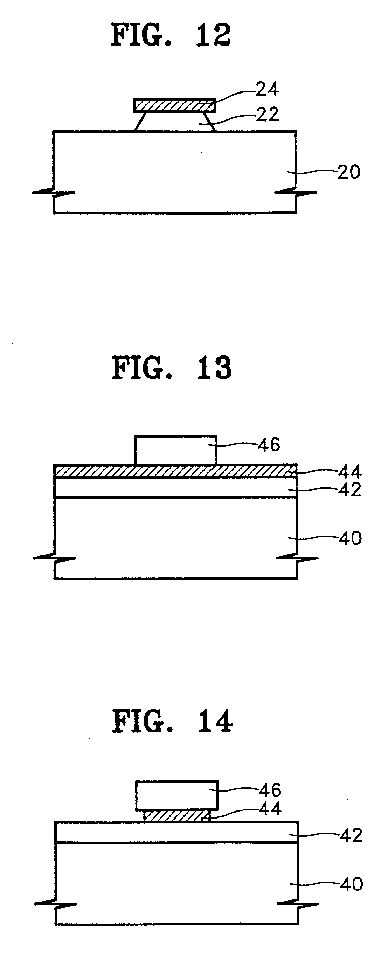

The first metal film 22 and the second metal film 24 which constitute the gate electrode in the first embodiment of the present invention are etched using only one mask. Therefore, an undercut may be generated in the gate electrode as shown in FIG. 12. As a result, step coverage becomes poor in a subsequent insulating film depositing process, thus creating a risk of deteriorating insulation characteristics. In the second through fourth embodiments of the present invention, a method for preventing the generation of the undercut in the gate electrode is provided.

FIGS. 13 through 16 are sectional views for explaining a method for manufacturing a liquid crystal display according to a second embodiment of the present invention. Here, the initial steps through the step of forming the gate electrode are shown.

FIG. 13 shows the step of forming the conductive films for the gate electrode. First, a first metal film 42 is formed by depositing an Al or Al alloy film to a thickness of 2,000-4,000Å on a transparent substrate 40. Then, a second metal film 44 to be used as a capping film is formed by depositing a refractory metal, such as Cr, Ta, Mo, or Ti, preferably Cr, on the first metal film 42. Here, Al-Nd or Al-Ta can be used as the Al alloy.

FIG. 14 shows the step of forming a photoresist pattern 46. A photoresist pattern 46 is formed by coating photoresist on the second metal film 44 and exposing and developing the photoresist. Then, a second metal film 44 is etched using the photoresist pattern 46 as a mask. At this time, an undercut is generated in the second metal film 44 by sufficiently overetching the second metal film.

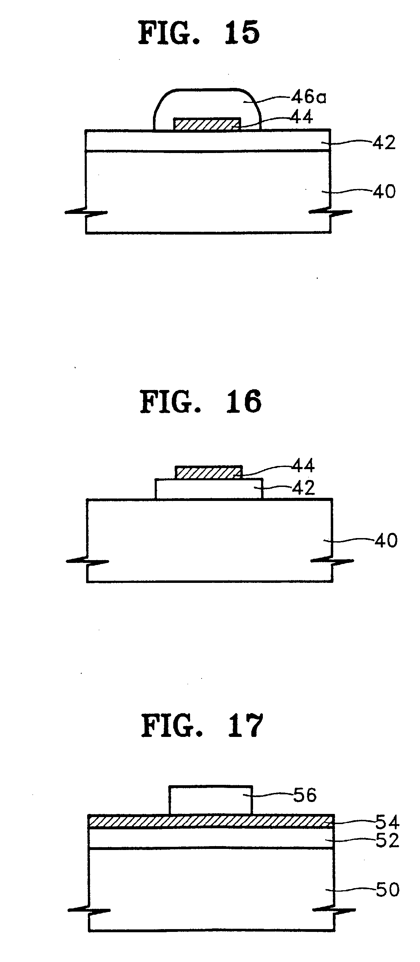

FIG. 15 shows the step of reflowing the photoresist. The substrate is heated to a temperature above 100°C to reflow the photoresist. At this time, a heat treatment may be performed on the substrate over multiple steps in order to improve the reflow characteristic of the photoresist. As a result, the patterned second metal film 44 is completely covered by the reflowed photoresist 46a.

FIG. 16 shows the steps of forming the gate electrode. A photoresist pattern is removed after etching the first metal film 42 using the reflowed photoresist pattern 46a of FIG. 15 as a mask. As a result, since the first metal film 42 is etched to be wider than the second metal film 44 by the thickness of the photoresist 46a of FIG. 15, the step coverage of the insulating film is favorably formed in a subsequent insulating film depositing process. At this time, to prevent the first metal film 42 from contacting the ITO layer to be formed in a subsequent process, it is preferable to control the thickness and the size of the photoresist pattern so as to form the patterned second metal film 44 to be larger than the contact hole for connecting the ITO layer and the gate pad.

The following steps are identical to those of the above-described first embodiment, so the explanation of those steps is omitted here and the reader is referred to the description of the first embodiment.

FIGS. 17 through 19 are sectional views for explaining a method for manufacturing a liquid crystal display according to a third embodiment of the present invention. Here, the initial steps through the step of forming the gate electrode are shown.

FIG. 17 shows the step of forming conductive films 52 and 54 for the gate electrode and a photoresist pattern 56, which is identical to the second embodiment in FIG. 13 of the present invention.

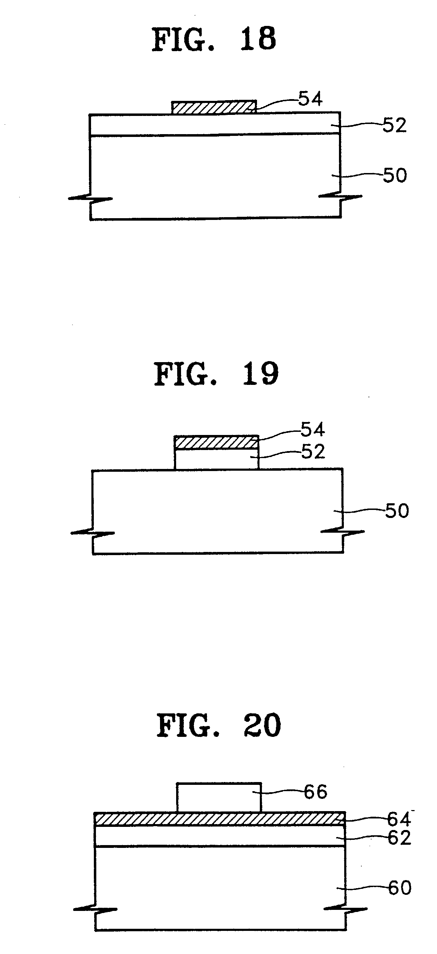

FIG. 18 shows the step of patterning the second metal film 54, in which the second metal film 54 is wet or dry etched using the photoresist pattern 56 of FIG. 17 as a mask. Then, the photoresist pattern is removed. The photoresist pattern is not necessarily removed in this step and may instead be removed after etching the first metal film 52.

In the case of wet etching the second metal film 54, an undercut may be generated to narrow the width of the first metal film to be etched later. At this time, if the photoresist pattern is not removed, baking may be performed on the photoresist pattern to prevent lifting of the photoresist pattern.

FIG. 19 shows the step of forming the gate electrode by etching the first metal film 52, in which the first metal film 52 is etched using the patterned second metal film 54 as a mask. Of course, in the case that the photoresist pattern is not removed in the previous step, the photoresist pattern can be used as a mask and the photoresist pattern is removed after etching the first metal film.

FIGS. 20 through 23 are sectional views for explaining a method for manufacturing a liquid crystal display according to a fourth embodiment of the present invention. Here, the initial steps through the step of forming the gate electrode are shown.

FIG. 20 shows the steps of forming conductive films 62 and 64 for the gate electrode and a photoresist pattern 66, which are identical to those of the second and the third embodiments.

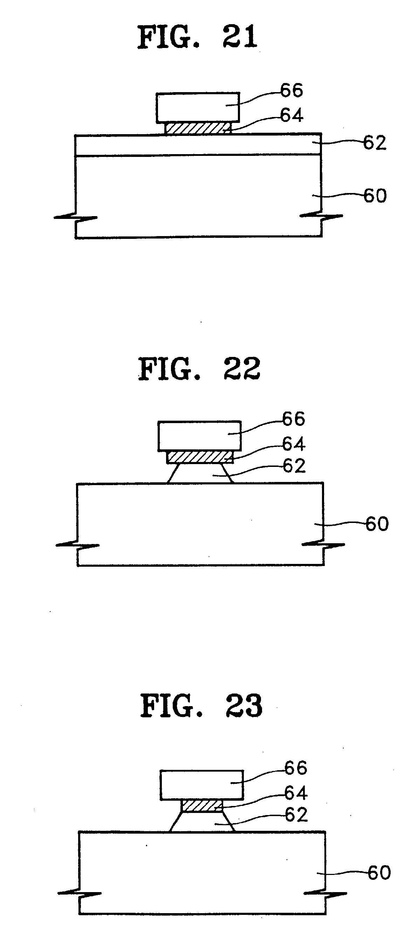

FIG. 21 shows the step of etching the second metal film, in which the second metal film 64 is wet etched using the photoresist pattern 66 as a mask. At this time, the second metal film is sufficiently etched so as to generate an undercut.

FIG. 22 shows the step of etching the first metal film, in which the undercut is formed in the gate electrode as shown in FIG. 12 when the first metal film 62 is wet etched using the patterned second metal film 64 as a mask.

FIG. 23 shows the step of re-etching the second metal film, in which the width of the lower portion of the first metal film 62 becomes wider than that of the second metal film 64 when the patterned second metal metal film 64 is re-etched, thus the undercut of the gate electrode is removed. Here, when etching the first metal film 62 or when re-etching the second metal film 64, baking may be performed on the second metal film 64 after performing the first etching on the second metal film 64, considering the case in which the lifting of the photoresist is generated.

According to the above-mentioned method for manufacturing the liquid crystal display according to the present invention, the gate electrode is formed in a two-layered-structure of Al or Al alloy and a refractory metal. Therefore, it is possible to prevent a battery effect caused by directly contacting the Al to the ITO layer and to prevent the generation of a hillock of the Al due to stress relaxation of the refractory metal. Also, it is possible to reduce the number of photolithography processes since it is possible to omit the anodizing process because of the refractory metal and to etch simultaneously the insulating film and the protection film.

Since it is possible to form the Al film or Al alloy film formed on the lower area so as to be either identical in size to or larger than the refractory metal formed on the upper portion, an undercut is not generated in the gate electrode. Therefore, it is possible to prevent the deterioration of insulation characteristics caused by poor step coverage.

The present invention is not restricted to the above embodiments, and it is clearly understood that many variations can be possible within the scope of the present invention by anyone skilled in the art.

## Claims

1. A method for manufacturing a liquid crystal display, the method comprising the steps of:
forming a gate electrode and a gate line on a substrate, wherein said gate electrode and said gate line comprises at least one refractory metal layer;
forming an insulating film on said gate electrode and said gate line;
forming an amorphous silicon film pattern and a doped amorphous silicon film pattern on said insulating film, wherein said doped amorphous silicon film pattern is formed entirely on said amorphous silicon film pattern and a whole bottom surface of said doped amorphous silicon film pattern is directly contacted to said amorphous silicon film pattern;
forming a source electrode and a drain electrode composed of a third metal film and then etching away a portion of said doped amorphous silicon film pattern located between said source electrode and said drain electrode;
forming a protection film pattern having a first contact hole which exposes a portion of said drain electrode and a second contact hole which exposes a portion of said gate line, wherein said protection film pattern contacts a top surface of said amorphous silicon pattern located between said source electrode and said drain electrode and said insulating film under said second contact hole is etched away to expose a portion of said gate line; and
forming a first pixel electrode pattern which is connected to said drain electrode through said first contact hole and a second pixel electrode pattern which is electrically connected to said gate line through said second contact hole.

2. The method for manufacturing a liquid crystal display as claimed in claim 1, wherein said gate electrode and said gate line further comprises Al or Al alloy layer which is formed between said substrate and said refractory metal layer.

3. The method for manufacturing a liquid crystal display as claimed in claim 1, wherein said refractory metal is one metal selected from the group of Cr, Mo, Ta and Ti.

4. The method for manufacturing a liquid crystal display as claimed in claim 2, wherein the side wall of said gate electrode comprising Al or Al alloy is inclined to said substrate.

5. The method for manufacturing a liquid crystal display as claimed in claim 1, wherein said protection film pattern is made of a nitride material.

6. The method for manufacturing a liquid crystal display as claimed in claim 4, wherein said first electrode and second electrode pattern is made of a transparent material.

7. The method for manufacturing a liquid crystal display as claimed in claim 1, wherein at least a portion of said drain electrode contacts said insulating layer.
